(19) **Europäisches Patentamt**
**European Patent Office**
**Office européen des brevets**

(11) **EP 3 121 145 B1**

(12) **EUROPEAN PATENT SPECIFICATION**

(45) Date of publication and mention
of the grant of the patent:
**21.10.2020 Bulletin 2020/43**

(51) Int Cl.:
***B81B 7/00*** *(2006.01)*

(21) Application number: **16180410.9**

(22) Date of filing: **20.07.2016**

(54) **MEMS DEVICE WITH FLEXIBLE TRAVEL STOPS AND METHOD OF FABRICATION**

MEMS-VORRICHTUNG MIT FLEXIBLEM ANSCHLAG UND VERFAHREN ZUR HERSTELLUNG

DISPOSITIF MEMS POURVU DE BUTÉES DE FIN DE COURSE FLEXIBLES ET PROCÉDÉ DE FABRICATION

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **23.07.2015 US 201514807665**

(43) Date of publication of application:
**25.01.2017 Bulletin 2017/04**

(73) Proprietor: **NXP USA, Inc.**
**Austin TX 78735 (US)**

(72) Inventor: **Naumann, Michael**
**5656 AG Eindhoven (NL)**

(74) Representative: **Hardingham, Christopher Mark**
**NXP Semiconductors**
**Intellectual Property Group**
**Abbey House**
**25 Clarendon Road**
**Redhill, Surrey RH1 1QZ (GB)**

(56) References cited:
**JP-A- 2011 112 620      US-A1- 2003 155 995
US-A1- 2008 173 959      US-A1- 2011 048 131**

Printed by Jouve, 75001 PARIS (FR)

**Description**

Field

This disclosure relates generally to microelectromechanical systems (MEMS) devices, and more specifically, to a MEMS device with flexible travel stops.

Related Art

Microelectromechanical systems (MEMS) devices are widely used in applications such as automotive, inertial guidance systems, household appliances, protection systems for a variety of devices, and many other industrial, scientific, and engineering systems. Such MEMS devices maybe used to sense a physical condition such as acceleration, angular velocity, pressure, or temperature, and to provide an electrical signal representative of the sensed physical condition. MEMS sensor designs are highly desirable for operation in high gravity environments and in miniaturized devices, and due to their relatively low cost.

JP2011112620 A (Mitsubishi Electric Corp) provides a sensor. A moveable mass is located above a substrate. An extended linear element protrudes from the lower surface of the moveable mass downwards, towards the substrate. When subject to acceleration, the moveable mass pivots. In a first range of pivotal movement, the sensor has a first rate of movement per unit increase in acceleration, providing a sensitive portion of an operation characteristic. At a given acceleration, the moveable mass pivots sufficiently that the extended linear element then contacts the substrate. That contact with the substrate is indicated by an electrode located on the substrate, on a point on the substrate where the extended linear element contacts the substrate. For accelerations greater than that required for the extended linear element to reach the substrate, the sensor has a lower rate of pivoting per unit increase in acceleration than the first rate of movement. In a second range of pivotal movement corresponding to accelerations above that necessary for the extended linear element to contact the substrate, therefore, the sensor has a less sensitive portion of its operation characteristic.

Summary

In accordance with a first aspect of the invention, an apparatus comprising the features of appended claim 1 is provided. In accordance with a second aspect of the invention, an apparatus comprising the features of appended claim 4 is provided. In accordance with a third aspect of the invention, a method comprising the steps of appended claim 12 is provided. The dependent claims provide further details of embodiments of the invention.

Brief Description of the Drawings

The present invention may be better understood, and its numerous objects, features, and advantages made apparent to those skilled in the art by referencing the accompanying drawings.

FIG. 1 and 2 each illustrate a top-down view diagram depicting prior art travel stops of MEMS devices.

FIG. 3 and 4 each illustrate a top-down view diagram depicting example flexible travel stop structures of MEMS devices in which the disclosure is implemented, according to some embodiments.

FIG. 5 illustrates a top-down view diagram depicting an example flexible travel stop configuration of a MEMS device, according to some embodiments.

FIG. 6 and 7 illustrate cross-sectional view diagrams depicting the example flexible travel stop configuration of FIG. 5.

FIG. 8 illustrates a top-down view diagram depicting another example flexible travel stop configuration of a MEMS device, according to some embodiments.

FIG. 9 illustrates a top-down view diagram depicting another example flexible travel stop configuration of a MEMS device, according to some embodiments.

FIG. 10 and 11 illustrate cross-sectional view diagrams depicting the example flexible travel stop configuration of FIG. 9.

FIG. 12 illustrates a top-down view diagram depicting another example flexible travel stop configuration of a MEMS device, according to some embodiments.

FIG. 13 illustrates a flowchart depicting a fabrication process for an example flexible travel stop structure in which the disclosure is implemented, according to some embodiments.

The present invention is illustrated by way of example and is not limited by the accompanying figures, in which like references indicate similar elements, unless otherwise noted. Elements in the figures are illustrated for simplicity and clarity and have not necessarily been drawn to scale.

Detailed Description

The following sets forth a detailed description of various embodiments intended to be illustrative of the invention and should not be taken to be limiting.

## Overview

One particular type of microelectromechanical systems (MEMS) device that is used in a variety of applications is an accelerometer. MEMS devices are sometimes operated in low pressure environments, such as in gyroscope applications where a MEMS accelerometer may be included as part of a combination device and placed in the same low pressure cavity as the gyroscope. Typically, a MEMS accelerometer includes (among other component parts) a movable element, also referred to as a proof mass. The proof mass is resiliently suspended above a substrate by one or more compliant suspension springs such that it moves when the MEMS accelerometer experiences acceleration. The motion of the proof mass may then be converted into an electrical signal having a parameter magnitude (e.g., voltage, current, frequency, etc.) that is proportional to the acceleration.

Due to the low viscous damping of the low pressure environment, the MEMS accelerometer may experience harsh accelerations or excessive force (e.g., the little to no air in the low pressure environment serves as an inadequate counterforce to slow movement of the accelerometer). While travel stops are typically used in accelerometers for limiting the excessive motion of the proof mass under relatively high acceleration, harsh accelerations can move the proof mass beyond a desired distance and cause severe impact forces between the travel stops and movable components. Such severe impact forces can potentially damage the MEMS accelerometer and possibly cause unstable behavior of the MEMS accelerometer. For example, severe impact forces can trigger different failure modes, such as chipping at contact surfaces that may lead to particle generation, fracture of structural components, and increased adhesion forces.

Commonly, two types of prior art travel stops are implemented to mitigate impact forces. Lateral travel stops are applied in lateral directions of the MEMS device to mitigate lateral displacement of MEMS structures parallel to the device substrate, such as a semiconductor substrate. However, such lateral travel stops fail to mitigate vertical displacement. Vertical travel stops are applied to mitigate vertical displacement, but such vertical travel stops are rigid and can cause significant impact force on MEMS structures during harsh acceleration.

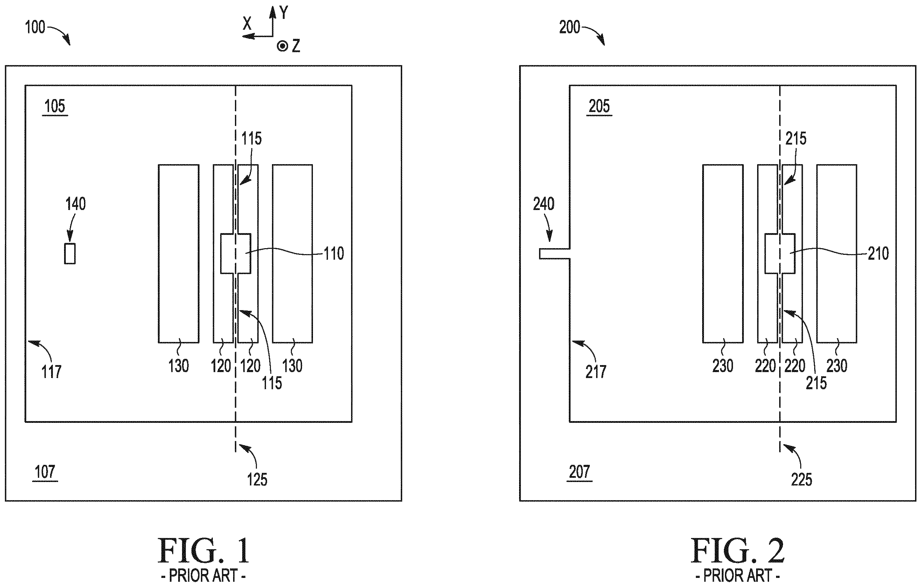

FIG. 1 illustrates an example MEMS device 100 that represents a typical single axis "teeter-totter" style accelerometer including one type of prior art rigid travel stop. MEMS device 100 includes a proof mass 105, an anchor 110 attached to a substrate 107 of MEMS device (also referred to as a device substrate), and torsion springs 115 connected between proof mass 105 and anchor 110. Proof mass 105 is suspended above and anchored to the device substrate 107 via anchor 110 and torsion springs 115. Anchor 110 and torsion springs 115 are separated from proof mass 105 by a number of openings 120, which allow proof mass 105 to move about an axis of rotation 125 (e.g., parallel to y-direction) centered through torsion springs 115. In the embodiment shown, a pair of electrodes 130 is attached to the device substrate 107 and underlie proof mass 105. Electrodes 130 are placed on both sides of axis 125. Prior art rigid travel stop 140 is applied on the device substrate 107 below proof mass 105. An example orientation of x-, y-, and z-axes are illustrated in FIG. 1, which is similarly utilized throughout the figures herein.

When MEMS device 100 experiences acceleration in a z-direction substantially perpendicular to the surface of proof mass 105, torsion springs 115 enable movement of proof mass 105 about rotational axis 125. As proof mass 105 rotates about axis 125, proof mass moves closer to one of the pair of electrodes 130 and father from the other electrode 130, altering the capacitances between proof mass 105 and electrodes 130. These capacitances are evaluated to determine acceleration in the z-direction. As the edge 117 of proof mass 105 moves towards the device substrate 107 (e.g., into the page), proof mass 105 makes contact with rigid travel stop 140, which may involve an excessive impact force during harsh acceleration due to the rigidity of the rigid travel stop 140.

FIG. 2 illustrates a MEMS device 200 similar to MEMS device 100 illustrated in FIG. 1. MEMS device 200 includes another type of prior art rigid travel stop. MEMS device 200 also includes a proof mass 205, an anchor 210 attached to a device substrate 207 of MEMS device 200, torsion springs 215 connected between proof mass 205 and anchor 210 to suspend proof mass 205 above the device substrate 207, openings 220 in proof mass 205 that separate anchor 210 and torsion springs 215 from proof mass 205, and electrodes 230 attached to the device substrate 207 underlying proof mass 205. Prior art rigid travel stop 240 is applied as a geometric stop extending from the edge 217 of proof mass 205. As the edge 217 of proof mass 205 moves towards the device substrate 207 (e.g., into the page), rigid travel stop 240 makes contact with the device substrate 207, which may involve an excessive impact force during harsh acceleration due to the rigidity of the rigid travel stop 240.

The present disclosure provides improved MEMS device shock robustness by applying flexible travel stops for contacts to the device substrate or device cap to mitigate vertical displacement. The vertical flexible travel stop includes a contact lever that is formed as part of the movable proof mass, where the contact lever allows a small elastic deformation that increases the deceleration time of the proof mass and mitigates the arising impact forces. The length of the contact lever (e.g., the distance between the axis of rotation and the contact region of the contact lever) is minimized in order to obtain maximal restoring forces and minimize the chance of stiction-induced device failure. In some embodiments, the vertical flexible travel stop is formed within or inside the movable proof mass and includes one or more torsion springs that attach the contact lever to the proof mass, where the torsion springs allow a further elastic deformation that increases the deceleration time of the proof mass. In some embodiments, the vertical flexible stop also includes a bumper on the device substrate that is aligned with the contact lever, where the contact lever makes contact with the bumper during harsh acceleration and distributes the impact forces.

Example Embodiments

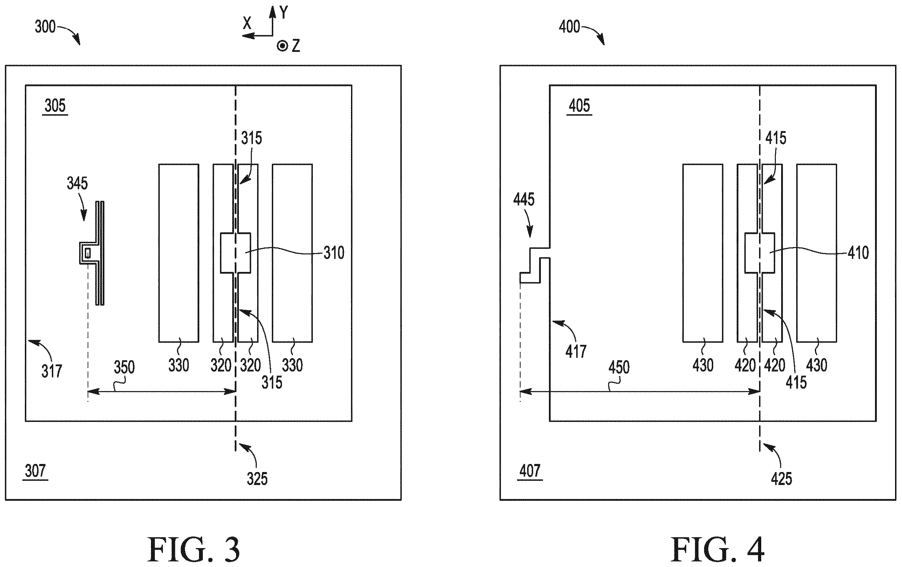

FIG. 3 illustrates a MEMS device 300 that includes an example flexible travel stop structure 345 in which the disclosure is implemented. MEMS device 300 includes a proof mass 305, an anchor 310 attached to a device substrate 307 of the MEMS device, and torsion springs 315 connected between the proof mass 305 and the anchor 310. The proof mass 305 is suspended above and anchored to the device substrate 307 via the anchor 310 and torsion springs 315. The anchor 310 and torsion springs 315 are separated from proof mass 305 by a number of openings 320, which allow the proof mass to move about a major axis of rotation 325 centered through torsion springs 315. A number of electrodes 330 are attached to the device substrate 307 and underlie proof mass 305. Movement of proof mass 305 alters capacitances between proof mass 305 and the electrodes 330, and these capacitances are utilized to determine acceleration in a z-direction. Electrodes 330 may include fixed or movable electrodes, sense electrodes, actuator electrodes, and the like. Other types of electrodes may also be implemented as part of MEMS device 300, such as electrodes that measure lateral acceleration (e.g., in an x-direction, in a y-direction, or both).

It is noted that the MEMS devices discussed herein in connection with FIG. 3 and subsequent figures are shown in simplified form for ease of understanding. As such, the MEMS devices may include a number of other structures and components that are not shown in the figures, such as having a number of anchors, torsion springs, openings, and electrodes different from the embodiments illustrated. For example, additional torsion springs may connect the anchor to the proof mass in a direction perpendicular to the illustrated torsion springs to create a second axis of rotation (e.g., one rotational axis along the y-direction and a perpendicular rotational axis along the x-direction of the plane of the proof mass' surface), allowing MEMS device 300 to rotate on both an x-axis and a y-axis. Such an embodiment may also include additional electrodes that measure acceleration of the proof mass in different directions. Additional flexible travel stop structures 345 may also be implemented elsewhere within the proof mass in other embodiments. It is also noted that the illustrations provided herein are not necessarily to scale and do not necessarily indicate correct proportions.

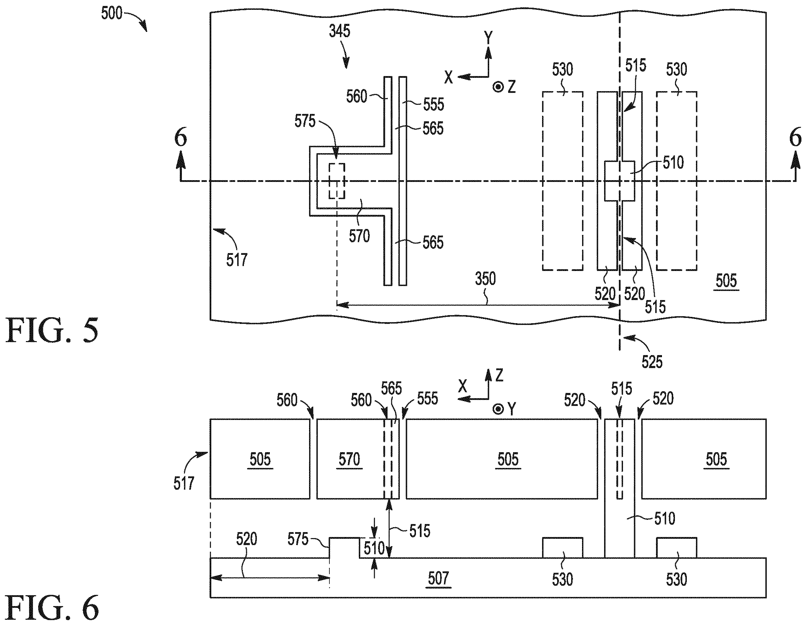

In the embodiment illustrated, flexible travel stop structure 345 is formed within proof mass 305 (e.g., interior to the perimeter of proof mass 305). Flexible travel stop structure 345 includes a flexible contact lever having an effective contact lever length 350, which is measured from a contact point of flexible travel stop structure 345 to rotational axis 325. The compliance of the flexible travel stop may be adjusted (e.g., the amount of deformation in response to the impact forces may be adjusted), as further discussed below. As the edge 317 of proof mass 305 moves toward the device substrate 307, flexible travel stop structure 345 makes contact with a bumper on the device substrate 307 that underlies flexible travel stop structure 345 and deforms elastically. The elastic deformation increases deceleration time of the proof mass and mitigates the impact force resulting from proof mass 305 making contact with the device substrate. Flexible travel stop structure 345 is described in further detail below in connection with FIG. 5.

FIG. 4 illustrates another MEMS device 400 that includes an example flexible travel stop structure 445 in which the disclosure is implemented. MEMS device 400 also includes a proof mass 405, an anchor 410 attached to a device substrate 407 of the MEMS device, torsion springs 415 connected between proof mass 405 and anchor 410 to suspend proof mass 405 above the device substrate, openings 420 in proof mass 405 that separate anchor 410 and torsion springs 415 from proof mass 405, and electrodes 430 attached to the device substrate underlying proof mass 405.

In the embodiment illustrated, flexible travel stop structure 445 is formed on an edge 417 of proof mass 405. Flexible travel stop structure 445 includes a flexible contact lever on the edge 417 of proof mass 405. In the embodiment shown, the contact lever includes two 90 degree "bends" to form the contact lever. In other embodiments, a different number of "bends" may be formed to adjust (e.g., increase or decrease) the compliance (e.g., adjust the amount of deformation in response to the impact forces) of the contact lever. Similarly, the bends may be formed at 90 degrees or some other angle to adjust (e.g., increase or decrease) flexibility. The width of the contact lever may also be adjusted to alter compliance. The contact lever of flexible travel stop structure 445 has an effective contact lever length 450 measured from the edge of the flexible contact lever (where contact is made with the device substrate) to rotation axis 425. As the edge 417 of proof mass 405 moves towards the device substrate 407, flexible travel stop structure 445 makes contact with the device substrate and deforms elastically. The elastic deformation increases deceleration time of the proof mass and mitigates the impact force resulting from proof mass 405 making contact with the device substrate.

FIG. 5 illustrates a top-down view diagram depicting an example flexible travel stop configuration of MEMS device 500 that includes flexible travel stop structure 345. Similar to MEMS device 300, MEMS device 500 includes a proof mass 505, an anchor 510 attached to a device substrate 507 (shown in FIG. 6) of the MEMS device 500, and torsion springs 515 connected between proof mass 505 and anchor 510. Anchor 510 and torsion springs 515 are separated from proof mass 505 by openings 520, which allow the proof mass to rotate about a major axis of rotation 525 centered through torsion springs 515. Electrodes 530 are attached to the device substrate 507 and underlie proof mass 505.

Flexible travel stop structure 345 includes a contact lever 570 and torsion springs 565, which are separated from proof mass 505 by openings 555 and 560. Opening 560 surrounds contact lever 570 on three sides: both sides parallel to the x-direction and on the terminal side (e.g., the side farthest from rotational axis 525) parallel to the y-direction. Opening 560 also extends laterally in the y-direction on either side of contact lever 570 to separate one side (e.g., the side farthest from rotational axis 325) of torsion springs 565 from proof mass 505. Opening 555 extends laterally in the y-direction on the remaining side of contact lever 570 (e.g., the side closest to rotational axis 525) and separates another side (e.g., the side closest to rotational axis 525) of torsion springs 565 from proof mass 505. Torsion springs 565 are connected between proof mass 505 and contact lever 570, where contact lever 570 moves about a minor axis of rotation centered through torsion springs 565 in the y-direction. Torsion springs of the flexible travel stop structure are also referred to as flexible elements.

The actual length of contact lever 570 (e.g., measured in the x-direction between openings 555 and 560) and the length of torsion springs 565 may be lengthened or shortened to adjust (e.g., increase or decrease) the compliance of flexible travel stop structure 345 (e.g., adjust the amount of deformation experienced by contact lever 570 in response to impact forces). Also, the width of torsion springs 565 may be thickened or thinned to adjust the compliance of flexible travel stop structure 345. In some embodiments, the actual length of the contact lever is within a range of 10 to 20 microns. In some embodiments, the length of the torsion springs is 60 microns. In some embodiments, the torsion springs are 2 or 3 microns wide.

In the embodiment illustrated in FIG. 5, contact lever 570 is aligned with a bumper 575 located below contact lever 570, which is positioned to make contact with contact lever 570 to reduce the possibility of the edge 517 of proof mass 505 making harsh contact with the underlying device substrate 507. It is noted that in the flexible travel stop configuration illustrated, flexible travel stop structure 345 is centered along a midline of MEMS device 500 in the x-direction, which is illustrated with broken line 6. The midline is a line equidistant from the opposing sides of MEMS device 500 parallel to the x-direction, and the midline is perpendicular to rotational axis 525. Flexible travel stop structure 345 may be positioned elsewhere within proof mass 505 in other embodiments, such as off-center of the MEMS device. In some embodiments, flexible travel stop structure 345 may be located midway between the rotational axis 525 and the edge 517 of MEMS device 500. In other embodiments, more than one flexible travel stop structure 345 may also be included elsewhere within proof mass 505, and a corresponding bumper 575 may be formed underneath such structures 345. A cross-sectional view of MEMS device 500 through line 6 is illustrated in FIG. 6.

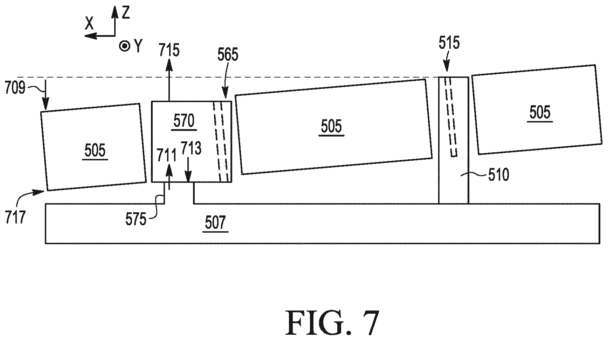

FIG. 6 illustrates a cross-sectional view diagram depicting the example flexible travel stop configuration of FIG. 5 at rest. Proof mass 505 is suspended over device substrate 507 by anchor 510 and torsion springs 515. Electrodes 530 are located on substrate 507 on either side of anchor 510. Proof mass 505 is separated from device substrate 507 by a distance 515. Bumper 575 has a height 510 that is a portion of the total distance 515 between proof mass 505 and device substrate 507. In some embodiments, height 510 is within a range of one third to one half of the total distance 515. In some embodiments, the total distance between the proof mass and the device substrate is 1.6 microns. In some embodiments, the height of the bumper is within a range of 0.5 to 0.9 microns. The height of electrodes 530 does not necessarily equal bumper height 510, and may likely be different from one another. Bumper 575 is also located a distance 520 from the edge 517 of proof mass 505. Bumper 575 is formed under contact lever 570 in a position configured to ensure contact is made with contact lever 570 when proof mass 505 moves down toward device substrate 507, as further shown in FIG. 7. While one rectangular bumper 575 is illustrated in FIG. 5 and 6, additional bumpers or differently shaped bumpers may be implemented in other embodiments.

FIG. 7 illustrates a cross-sectional view diagram depicting the example flexible travel stop configuration of FIG. 5 in motion. Electrodes 530 are omitted from FIG. 7 for ease of illustration. Edge 517 of proof mass 505 is shown rotating toward (e.g., down) device substrate 507, as proof mass 505 rotates around rotational axis 525. Direction of movement 709 indicates movement of proof mass 505 due to some external acceleration load or force. Contact lever 570 is shown to make contact with bumper 575, where impact force 711 due to contact with bumper 575 pushes flexible travel stop structure 345 upward. Bumper 575 is positioned to mitigate impact force 711 experienced by proof mass 505, as well as reduce the possibility of the corner 717 of edge 517 of proof mass 505 from making harsh contact with substrate 507.

As proof mass 505 moves downward, the upward-directed force 711 of contact lever 570 counteracts the external acceleration force and slows the downward movement of proof mass 505 (i.e., the deceleration time of proof mass 505 is increased). Once contact lever 570 has made contact with bumper 575, adhesion forces 713 may continue to hold contact lever 570 in contact with bumper 575 (e.g., pull contact level 570 down), and thus pull proof mass 505 down toward substrate 507 even after the external acceleration force has decayed. Adhesion forces typically occur between two micromachined surfaces in contact, which may lead to stiction-induced failure. It is noted that the magnitude of impact force 711 correlates to the magnitude of external force, where a larger external force results in a larger impact force 711, which results in a larger displacement of contact lever 570.

As contact lever 570 is elastically deformed upward, torsion springs 565 store mechanical energy, which is released as an elastic restoring force 715 that acts in the upward direction (e.g., contact lever 570 "pushes off' bumper 575) to bring contact lever 570 and proof mass 505 back toward equilibrium. Such restoring force 715 counteracts adhesion forces 713 (e.g., 715 and 713 are in opposing directions), which is also referred to as peel-off effect. Also, as proof mass 505 moves downward, torsion springs 515 store mechanical energy that is similarly released as an elastic restoring force acting in the upward direction to bring proof mass 505 back toward equilibrium (e.g., the position of proof mass 505 at rest, illustrated in FIG. 6). It is noted that flexible travel stop 345 provides restoring force 715 in addition to the restoring force provided by torsion springs 515, while prior art rigid travel stops like that shown in FIG.1 and 2 only experience restoring force provided by torsion springs 115 and 215.

It is noted that the effective contact lever length ($L_{CON}$) defines the restoring forces ($F_{RES}$) provided by a structure (like MEMS device 500) for a given restoring moment ($M_{RES}$) provided by the torsion springs (like torsion springs 515), where $M_{RES}$ is defined by a given torsional stiffness of the torsion springs. In other words, the relationship between $F_{RES}$, $M_{RES}$, and $L_{CON}$ is summarized by:

$$F_{RES} = M_{RES} / L_{CON}$$

Accordingly, the magnitude of $F_{RES}$ is inversely proportional to the magnitude of $L_{CON}$. It is noted that it is preferred for the effective length ($L_{CON}$) 350 of contact lever 570 to be minimized in order to achieve a maximum restoring force ($F_{RES}$), which in turn minimizes the chance of stiction-induced (or mechanical-induced) device failure.

For comparison, contact lever 570 has an effective length 350 that is measured from point of contact of contact lever 570 on bumper 575 to rotational axis 525 (shown in FIG. 5), while flexible travel stop structure 445 has an effective length 450 that is measured from point of contact of the lever of structure 445 on substrate 407 to rotational axis 425 (shown in FIG. 4). Effective length 350 is shorter than effective length 450, due to contact lever 570 being placed within proof mass 505 instead of at the edge 517 of proof mass 505. Since contact lever 570 makes contact with bumper 575 rather than the underlying substrate 507, contact lever 570 is able to be moved away from edge 517 of proof mass 505 by distance 520, which shortens the effective contact lever length. Assuming that springs 415 and 515 have comparable stiffness, the restoring force experienced by proof mass 505 that includes structure 345 (with shorter length 350) is greater than the restoring force experienced by proof mass 405 that includes structure 445 (with longer length 450).

In other words, restoring forces are increased and impact forces are reduced when implementing a flexible travel stop structure 345 within a proof mass in combination with an underlying bumper 575 in a MEMS device. An illustrative example is provided, where a MEMS device that experiences a half-sine 1000g shock acceleration in z-direction would cause a prior art rigid travel stop to experience on the order of a 1000 uN (micro Newton) impact force, which may cause the rigid travel stop to deform and possibly cause the proof mass to stick or adhere to the rigid travel stop. Further, the typical restoring force exhibited by the rigid travel stop is minimal, such as 1 to 2 uN. By contrast, a flexible travel stop structure 345 having 2000 N/m stiffness reduces the impact force experienced by the underlying bumper to 250 uN, which reduces the risk of deformation and adhesion. In such examples, a flexible travel stop structure 345 may reduce impact forces up to 75%. Also, the contact lever is pulled from the underlying bumper by a tensile force (or additional restoring force) that counterbalances the adhesion forces experienced by the contact lever. For comparison, the additional restoring force exhibited by the flexible travel stop structure would be on the order of 150uN. This "peel-off' effect virtually increases restoring forces, which improves the changes for proof mass returning toward equilibrium without stiction-induced device failure.

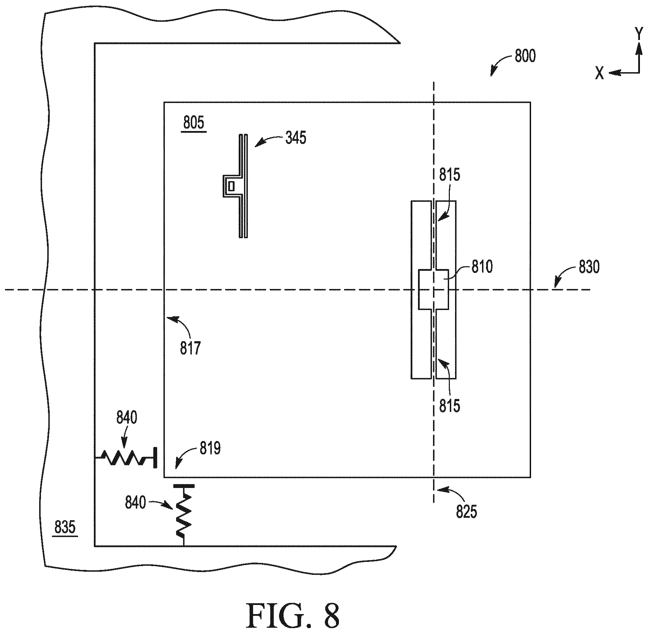

Additionally, since each bumper may experience an adhesion force upon contact with the proof mass, it is preferred that the number of bumpers is minimized in order to avoid the resulting adhesion forces from overcoming the constant non-increasing restoring force of torsion springs 515. The number of bumpers can be minimized by selecting the placement of the bumpers for optimum load distribution, such as that configuration shown in FIG. 8. It is also noted that a shorter contact lever (e.g., measured from the rotational axis to the point of contact of the contact lever) results in a greater restoring force, indicating that the placement of flexible travel stop structure 345 within proof mass should also be selected to optimize the restoring forces experienced by the proof mass.

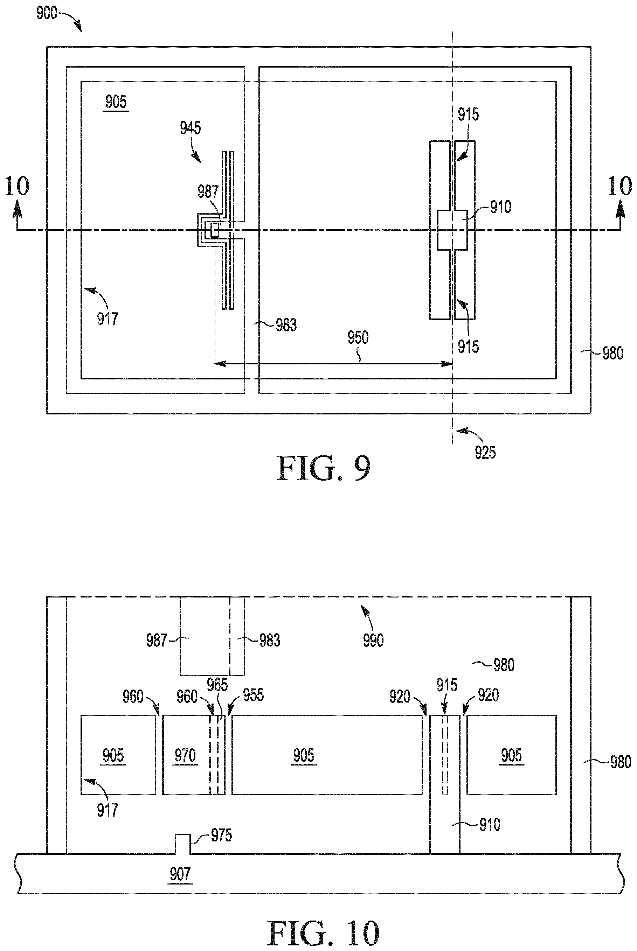

FIG. 8 illustrates a top-down view diagram depicting another example flexible travel stop configuration of a MEMS device 800 that includes flexible travel stop structure 345, proof mass 805, anchor 810, and torsion springs 815. Electrodes are omitted for ease of illustration. In the configuration illustrated, flexible travel stop structure 345 is positioned off-center, where the midline of MEMS device 800 is illustrated as broken line 830. Flexible travel stop structure 345 may be positioned elsewhere within proof mass 805 in other embodiments. In the example shown, flexible travel stop structure 345 is positioned in one quadrant of MEMS device 800 (e.g., illustrated in FIG. 8 as left of rotational axis 825 and above midline 830). MEMS device 800 also includes a surrounding structure 835 (such as a cap, further discussed below in connection with FIG. 9) that is attached to the substrate and at least laterally surrounds proof mass 805. Surrounding structure 835 in turn includes a pair of lateral stops 840 configured to mitigate lateral impact forces between proof mass 805 and surrounding structure 835 in the x- and y-directions. As proof mass 805 experiences an external force, proof mass 805 moves toward the underlying substrate in the z-direction (e.g., into the page) and flexible travel stop structure 345 makes contact with an underlying bumper and begins to slow the movement of proof mass 805. Midline 830 also delineates a second major rotational axis perpendicular to the first major rotational axis 825, where proof mass 805 may rotate around axis 830 in response to due to the momentum of proof mass 805 resulting from the off-center position of structure 345.

Restoring forces vary as the magnitude of the external force on proof mass 805 increases. If a light shock acceleration in the z-direction occurs, structure 345 makes contact with the underlying bumper, which may result in relatively small restoring forces at structure 345. If a medium shock acceleration in the z-direction occurs, proof mass 805 rotates around axis 825 and structure 345 makes contact with the underlying bumper. Proof mass 805 may also begin rotating around axis 830, where corner 819 continues to move toward the substrate. If the shock acceleration is great enough, corner 819 makes contact with the underlying substrate. While the corner 819 may experience adhesion with the underlying substrate even after the external force on proof mass 805 has decayed, the additional deformation of springs 815 (due to rotation around 830) cause restoring forces at corner 819 to counterbalance such adhesion, or peel-off from the substrate. It is noted that the off-center position of structure 345 enables larger restoring forces at corner 819 than if structure 345 were centered along midline 830 (which would prevent rotation around axis 830, in turn preventing the additional restoring forces from springs 815). Structure 345 experiences compressive contact forces until corner 819 releases.

If a large shock acceleration in the x-direction occurs, structure 345 makes contact with the underlying bumper, corner 819 makes contact with the underlying substrate, and the edge 817 continues to move toward the substrate. If the shock acceleration is great enough, the entire edge 817 makes contact with the underlying substrate. The contact lever of structure 345 is deformed at a greatest amount during such a large shock acceleration. Restoring forces act along the entire edge 817, with the highest magnitude restoring force at edge portions close to structure 345, which counterbalance any adhesion forces acting on the edge 817, resulting in peel-off for the edge 817. Structure 345 experiences compressive contact forces until the edge 817 and corner 819 release.

It is preferred for flexible travel stop structure 345 to be positioned to mitigate such movement toward the underlying substrate and prevent such harsh contact. By utilizing the flexible travel stop structure 345, the impact forces are distributed among multiple points of contact depending on the severity of the shock acceleration in the z-direction, where such load distribution reduces the magnitude of impact forces arising at each individual contact spot, and similarly reduces the risk of device failure.

FIG. 9 illustrates a top-down view diagram depicting another example flexible travel stop configuration of a MEMS device 900 that includes flexible travel stop structure 945, proof mass 905, anchor 910, torsion springs 915, and cap 980. Electrodes are omitted for ease of illustration. Cap 980 is a surrounding structure attached to the substrate that extends laterally around proof mass 905 and above proof mass 905 and is configured to protect the moveable elements of MEMS device 900. Cap 980 includes bar 983 that spans across MEMS device 900 near the flexible travel stop structure 945. Bar 983 also includes an extension 987 that aligns over the contact lever of flexible travel stop structure 945. In some embodiments, cap 980 and bar 983 are formed from polysilicon. In the embodiment illustrated, flexible travel stop structure 945 is centered on a midline of MEMS device 900 illustrated as broken line 10, but may be positioned elsewhere within proof mass 905 in other embodiments, such as off-center. Similarly, in the embodiment illustrated, extension 987 is also centered on the midline 10 of MEMS device 900, but may be positioned elsewhere over flexible travel stop structure 945. A cross-sectional view of MEMS device 900 through line 10 is illustrated in FIG. 10.

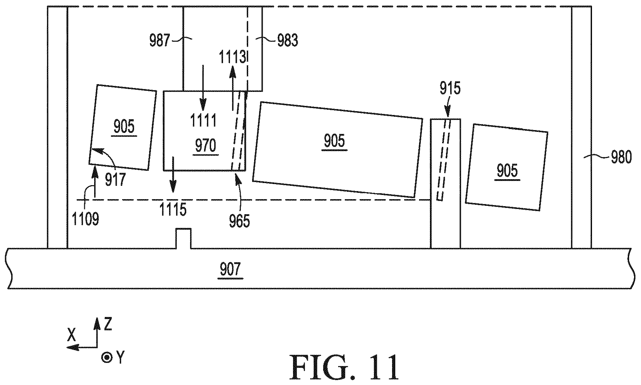

FIG. 10 illustrates a cross-sectional view diagram depicting the example flexible travel stop configuration of FIG. 9 at rest. Electrodes are omitted for ease of illustration. Proof mass 905 is suspended over device substrate 907 by anchor 910 and torsion springs 915. In the embodiment illustrated, bumper 975 is located under contact lever 970 of flexible travel stop structure 945 in a position configured to ensure contact is made with contact lever 970 when the edge 917 of proof mass 905 moves toward device substrate 907, similar to that shown above in connection with FIG. 7. In other embodiments, MEMS device 900 does not include bumper 975 aligned under contact lever 970, and may instead include another manner of mitigating impact forces in the z-direction toward substrate 907. Cap 980 is attached to and extends up from device substrate 907 and surrounds proof mass 905, leaving a cavity 990 above proof mass 905. In some embodiments, cavity 990 is 10 to 20 microns deep. Bar 983 extends across cavity 990 near flexible travel stop structure 945. In some embodiments, bar 987 has a width of 5 to 10 microns. Extension 987 extends from bar 983 and is located over contact lever 970 of flexible travel stop structure 945 in a position configured to ensure contact is made with contact lever 970 when the edge 917 of proof mass 905 moves away from device substrate 907, as further shown in FIG. 11.

FIG. 11 illustrates a cross-sectional view diagram depicting the example flexible travel stop configuration of FIG. 9 in motion. Electrodes are omitted for ease of illustration. Edge 917 of proof mass 905 is shown rotating away (e.g., up) from device substrate 907, as proof mass 905 rotates around rotational axis 925. Direction of movement 1109 indicates movement of proof mass 905 due to some external acceleration force. Contact lever 970 is shown to make contact with extension 987, where impact force 1111 due to contact with extension 987 pushes flexible travel stop structure 945 downward. Extension 987 is positioned to mitigate impact force 1111 experienced by proof mass 905.

As proof mass 905 moves upward, the downward-directed force 1111 of contact lever 970 counteracts the external acceleration force and slows the upward movement of proof mass 905 (i.e., the deceleration time of proof mass 905 is increased). Once contact lever 970 has made contact with extension 987, adhesion forces 1113 may continue to hold contact lever 970 in contact with extension 987 (e.g., pull contact lever 970 up), and thus pull proof mass 905 up even after the external acceleration force has decayed.

As contact lever 970 is elastically deformed downward, torsion springs 965 store mechanical energy, which is released as an elastic restoring force 1115 that acts in the downward direction (e.g., contact lever 970 "pushes off" extension 987) to bring contact lever 970 and proof mass 905 back toward equilibrium. Such restoring force 1115 counteracts adhesion forces 1113 (e.g., 1115 and 1113 are in opposing directions) and results in peel-off. Also, as proof mass 905 moves upward, torsion springs 915 store mechanical energy that is similarly released as an elastic restoring force acting in the downward direction to bring proof mass 905 back toward equilibrium (e.g., the position of proof mass 905 at rest, illustrated in FIG. 10). As similarly discussed above, the length 950 of contact lever 970 (measured from point of contact of contact lever 970 on extension 987 to rotational axis 925 axis) is similarly configured to be a minimal length in order to achieve a maximum restoring force 1115, which minimizes the change of stiction-induced device failure as discussed above.

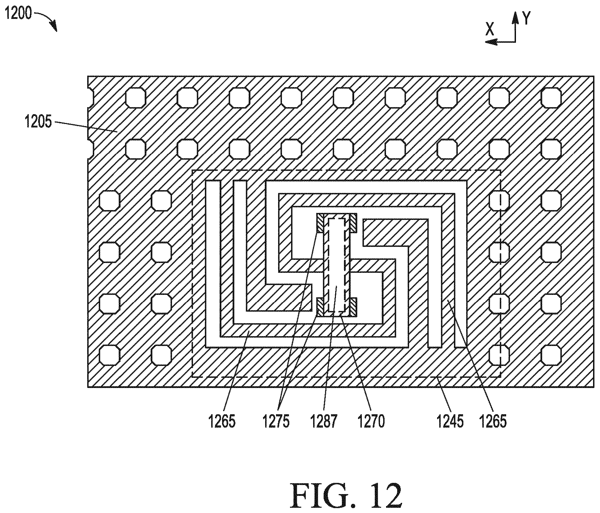

FIG. 12 illustrates a top-down view diagram depicting another example travel stop configuration of a MEMS device 1200 that includes flexible travel stop structure 1245. Flexible travel stop structure 1245 is formed in an area within proof mass 1205, as indicated by a broken line. Flexible travel stop structure 1245 may be utilized in MEMS devices like those shown in FIG. 5, FIG. 8 and FIG. 9 (e.g., replacing the illustrated flexible travel stop structure and bumper in those devices). Flexible travel stop structure 1245 includes contact lever 1270 and one or more flexible elements 1265 connected between proof mass 1205 and contact lever 1270. Flexible elements 1265 connect to a center portion of contact lever 1270, providing two ends of contact lever 1270 that extend laterally in opposite directions that are parallel to the y-axis. Flexible elements 1265 are formed within a more compact area of proof mass 1205, as compared to the area occupied by torsion springs like those illustrated in FIG. 3. The flexibility of flexible elements 1265 (and of flexible travel stop structure 1245) can be adjusted by a different number of "bends." Similarly, thicker or thinner width of the flexible elements 1265 also adjusts the flexibility of flexible elements 1265. Bumpers 1275 are located under each end of contact lever 1270 and are located in a position configured to ensure contact is made with each end of contact lever 1270 when proof mass 1205 moves down toward the underlying device substrate, similar to that shown above in connection with FIG. 7. In the embodiment illustrated, extension 1287 is aligned over contact lever 1270 of flexible travel stop structure 1245, and is outlined by a broken line. Although not shown, extension 1287 is connected to a bar of a cap that surrounds proof mass 1205 and is located in a position configured to ensure contact is made with contact lever 1270 when proof mass 1205 moves up away from the underlying device substrate, similar to that shown above in connection with FIG. 9.

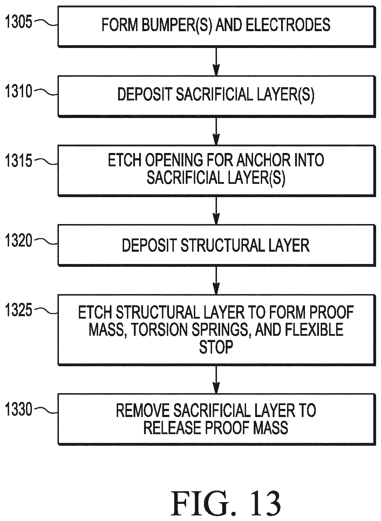

FIG. 13 illustrates a flowchart depicting a fabrication process for a flexible travel stop structure on a MEMS device. The fabrication process is simplified for ease of understanding. The components of the flexible travel stop structure may be produced by utilizing current and upcoming micromachining techniques of depositing, patterning, etching, and the like. It should be further understood that the use of relational terms, if any, such as first and second, top and bottom, and the like are used to distinguish one from another entity or action without necessarily requiring or implying any actual such relationship or order between such entities or actions. Additionally, other processes not discussed herein may be utilized to form other components of the MEMS device, such as the electrodes.

The process begins at operation 1305, where one or more bumpers are formed on a device substrate. In some embodiments, a top layer of the device substrate is etched to form the bumper(s). In other embodiments, a layer of polysilicon is deposited over the device substrate, which is then etched to form the bumper(s). Operation 1305 also includes forming electrodes on the device substrate, where the electrodes will be used to determine acceleration in at least a z-direction, and may include electrodes to also determine acceleration in an x-direction, a y-direction, or both. The process continues to operation 1310, where one or more sacrificial layers are deposited over the formed bumper(s). The sacrificial layer(s) occupy the space over the device substrate and will be removed later to release the proof mass.

The process continues to operation 1315, where at least one opening is etched into the sacrificial layer(s) for the anchor. The opening extends through the sacrificial layer(s) and exposes the surface of the device substrate. The opening defines the space within which the anchor will be formed. The process continues to operation 1320, where a structural layer is deposited over the sacrificial layer(s) and within the opening. In some embodiments, the structure layer includes polysilicon. The process continues to operation 1325, where the structural layer is etched to form the proof mass, torsion springs, and flexible travel stop structure. Operation 1325 also includes etching the structural layer to form electrode openings within the proof mass, if any are needed for the electrodes that measure acceleration in an x- or a y-direction (formed in operation 1305). The process continues to operation 1330, where the sacrificial layer is removed to release the proof mass. The process then ends.

By now it should be appreciated that there has been provided flexible travel stop structures that improve MEMS device shock robustness.

The MEMS devices described herein may be implemented on a semiconductor substrate, which can be any semiconductor material or combinations of materials, such as gallium arsenide, silicon germanium, silicon-on-insulator (SOI), silicon, monocrystalline silicon, the like, and combinations of the above.

Because the apparatus implementing the present invention is, for the most part, composed of electronic components and circuits known to those skilled in the art, circuit details will not be explained in any greater extent than that considered necessary as illustrated above, for the understanding and appreciation of the underlying concepts of the present invention and in order not to obfuscate or distract from the teachings of the present invention.

Moreover, the terms "front," "back," "top," "bottom," "over," "under" and the like in the description and in the claims, if any, are used for descriptive purposes and not necessarily for describing permanent relative positions. It is understood that the terms so used are interchangeable under appropriate circumstances such that the embodiments of the invention described herein are, for example, capable of operation in other orientations than those illustrated or otherwise described herein.

Thus, it is to be understood that the configuration of devices and structures depicted herein are merely exemplary, and that in fact many other configurations can be implemented, which also mitigate impact forces.

As used herein the terms "substantial" and "substantially" mean sufficient to accomplish the stated purpose in a practical manner and that minor imperfections, if any, are not significant for the stated purpose.

Although the invention is described herein with reference to specific embodiments, various modifications and changes can be made without departing from the scope of the present invention as set forth in the claims below. Accordingly, the specification and figures are to be regarded in an illustrative rather than a restrictive sense, and all such modifications are intended to be included within the scope of the present invention. Any benefits, advantages, or solutions to problems that are described herein with regard to specific embodiments are not intended to be construed as a critical, required, or essential feature or element of any or all the claims.

Furthermore, the terms "a" or "an," as used herein, are defined as one or more than one. Also, the use of introductory phrases such as "at least one" and "one or more" in the claims should not be construed to imply that the introduction of another claim element by the indefinite articles "a" or "an" limits any particular claim containing such introduced claim element to inventions containing only one such element, even when the same claim includes the introductory phrases "one or more" or "at least one" and indefinite articles such as "a" or "an." The same holds true for the use of definite articles.

Unless stated otherwise, terms such as "first" and "second" are used to arbitrarily distinguish between the elements such terms describe. Thus, these terms are not necessarily intended to indicate temporal or other prioritization of such elements.

**Claims**

1. A microelectromechanical systems, MEMS, device comprising:

   a substrate (307, 407, 507, 907);
   a proof mass (305, 405, 505, 805, 905, 1205) positioned in space above a surface of the substrate, wherein the proof mass is configured to move relative to the substrate;
   a flexible travel stop structure (345, 445, 945, 1245) formed within the proof mass, wherein the flexible travel stop structure comprises a contact lever (470, 570, 970, 1270) connected to the proof mass via flexible elements (315, 415, 515, 565, 815, 915, 965, 1265); and
   a bumper (575, 975, 1275) formed on the surface of the substrate, wherein
   the contact lever (470, 570, 970, 1270) is aligned to make contact with the bumper (575, 975, 1275) when the proof mass moves toward the substrate;
   wherein a lower surface of the contact lever (470, 570, 970, 1270) is co-planar with a lower surface of the proof mass (305, 405, 505, 805, 905, 1205), prior to contact with the bumper (575, 975, 1275).

2. The MEMS device of claim 1, wherein the flexible travel stop structure (345, 445, 945, 1245) is configured to elastically deform to mitigate vertical impact forces between the proof mass (305, 405, 505, 805, 905, 1205) and the substrate (307, 407, 507, 907).

3. The MEMS device of claim 1 or claim 2, wherein the flexible elements (1265) are connected to a center portion of the contact lever (1270),
the contact lever (1270) has two ends extending in opposite directions,
one end of the contact lever (1270) is aligned to make contact with the bumper (1275), and another end of the contact lever (1270) is aligned to make contact with another bumper (1275).

4. A microelectromechanical systems, MEMS, device comprising:

   a substrate (907);
   a proof mass (905) positioned in space above a surface of the substrate, wherein the proof mass is configured to move relative to the substrate;
   a flexible travel stop structure (945) formed within the proof mass, wherein
   the flexible travel stop structure (945) comprises a contact lever (970) connected to the proof mass (905) via flexible elements (1265); and
   a cap structure (980) attached to the surface of the substrate (907) that extends above the proof mass (905), wherein

      the cap structure (980) comprises an extension (987) aligned with the contact lever (970), and
      the contact lever (970) is aligned to make contact with the extension when the proof mass (905) moves away from the substrate (907).

5. The MEMS device of any one of the preceding claims, wherein
   the flexible elements of the flexible travel stop structure comprise torsion springs (315, 415, 515, 565, 815, 915, 965, 1265).

6. The MEMS device of any one of the preceding claims, wherein
   the flexible elements (1265) of the flexible travel stop structure comprise structural elements bent to fit within a compact area within the proof mass (1205).

7. The MEMS device of any one of the claims 4 to 6, wherein
   the flexible travel stop structure (945) is configured to elastically deform to mitigate vertical impact forces between the proof mass (905) and the cap structure (980).

8. The MEMS device of any one of the claims 4 to 7, further comprising:
   a bumper (975) formed on the surface of the substrate (907), wherein
   the contact lever (970) is aligned to make contact with the bumper (975) when the proof mass (905) moves toward the substrate (907).

9. The MEMS device of claim 8, wherein
   the flexible elements (965) are connected to a center portion of the contact lever (1270),
   the contact lever (1270) has two ends extending in opposite directions,
   one end of the contact lever (1270) is aligned to make contact with the bumper (1275), and another end of the contact lever (1270) is aligned to make contact with another bumper (1275).

10. The MEMS device of any one of the preceding claims, wherein
    the flexible travel stop structure (345, 445, 945, 1245) is centered along or is off-centered from a midline (830) of the MEMS device,
    the midline is equidistant from two parallel sides of the MEMS device, and
    the midline is perpendicular to a rotational axis (825) about which the proof mass moves.

11. The MEMS device of any one of the preceding claims, further comprising:
    a surrounding structure (835) that laterally surrounds the proof mass (805), wherein
    the surrounding structure (835) comprises one or more lateral stops (840) configured to mitigate lateral impact forces between the proof mass (805) and the surrounding structure (835).

12. A method of fabricating a microelectromechanical systems, MEMS, device comprising:

    forming (1305) at least one bumper (575, 975, 1275) on a substrate (307, 407, 507, 907);
    depositing (1310) at least one sacrificial layer over the at least one bumper;
    etching (1315) at least one opening for an anchor (910) into the at least one sacrificial layer;
    depositing (1320) a structural layer over the at least one sacrificial layer and within the at least one opening;
    etching (1325) the structural layer to form a proof mass (305, 405, 505, 805, 905, 1205) and a flexible travel stop structure (345, 445, 045, 1245) within the proof mass, wherein the etching comprises:
    etching a first opening and a second opening to form a contact lever (470, 570, 970, 1270) and torsion springs (315, 415, 515, 565, 815, 915, 965, 1265) connecting the contact lever to the proof mass, wherein the contact lever is aligned with the at least one bumper; and
    removing (1330) the sacrificial layer to release the proof mass, wherein the proof mass is configured to move relative to a surface of the substrate;
    wherein a lower surface of the contact lever (470, 570, 970, 1270) is co-planar with a lower surface of the proof mass (305, 405, 505, 805, 905, 1205).

## Patentansprüche

1. Mikroelektromechanische Systeme-, MEMS, -Vorrichtung, Folgendes umfassend:

   ein Substrat (307, 407, 507, 907);
   eine seismische Masse (305, 405, 505, 805, 905, 1205), die im Raum über einer Oberfläche des Substrats positioniert ist, wobei die seismische Masse eingerichtet ist, um sich hinsichtlich des Substrats zu bewegen;
   eine flexible Anschlagstruktur (345, 445, 945, 1245), die innerhalb der seismischen Masse ausgebildet ist, wobei
   die flexible Anschlagstruktur einen Kontakthebel (470, 570, 970, 1270) umfasst, der mit der seismischen Masse über flexible Elemente (315, 415, 515, 565, 815, 915, 965, 1265) verbunden ist; und
   einen Stoßdämpfer (575, 975, 1275), der auf der Oberfläche des Substrats ausgebildet ist, wobei der Kontakthebel (470, 570, 970, 1270) ausgerichtet ist, um den Stoßdämpfer (575, 975, 1275) zu kontaktieren, wenn sich die seismische Masse in Richtung auf das Substrat bewegt;
   wobei eine untere Oberfläche des Kontakthebels (470, 570, 970, 1270) vor einem Kontakt mit dem Stoßdämpfer (575, 975, 1275) koplanar mit einer unteren Oberfläche der seismischen Masse (305, 405, 505, 805, 905, 1205) ist.

2. MEMS-Vorrichtung nach Anspruch 1, wobei die flexible Anschlagstruktur (345, 445, 945, 1245) eingerichtet ist, um sich elastisch zu deformieren, um vertikale Stoßkräfte zwischen der seismischen Masse (305, 405, 505, 805, 905, 1205) und dem Substrat (307, 407, 507, 907) abzuschwächen.

3. MEMS-Vorrichtung nach Anspruch 1 oder 2, wobei die flexiblen Elemente (1265) mit einem Mittenabschnitt des Kontakthebels (1270) verbunden sind, der Kontakthebel (1270) zwei Enden aufweist, die sich in entgegengesetzte Richtungen erstrecken, ein Ende des Kontakthebels (1270) ausgerichtet ist, um den Stoßdämpfer (1275) zu kontaktieren, und ein anderes Ende des Kontakthebels (1270) ausgerichtet ist, um einen anderen Stoßdämpfer (1275) zu kontaktieren.

4. Mikroelektromechanische Systeme-, MEMS, -Vorrichtung, Folgendes umfassend:

   ein Substrat (907);
   eine seismische Masse (905), die im Raum über einer Oberfläche des Substrats positioniert ist, wobei die seismische Masse eingerichtet ist, um sich hinsichtlich des Substrats zu bewegen;
   eine flexible Anschlagstruktur (945), die innerhalb der seismischen Masse ausgebildet ist, wobei
   die flexible Anschlagstruktur (945) einen Kontakthebel (970) umfasst, der über flexible Elemente (1265) mit der seismischen Masse (905) verbunden ist; und
   eine Kappenstruktur (980), die an der Oberfläche des Substrats (907) befestigt ist, die sich über der seismischen Masse (905) erstreckt, wobei
   
   die Kappenstruktur (980) eine Erweiterung (987) umfasst, die mit dem Kontakthebel (970) ausgerichtet ist, und
   der Kontakthebel (970) ausgerichtet ist, um die Erweiterung zu kontaktieren, wenn sich die seismische Masse (905) von dem Substrat (907) wegbewegt.

5. MEMS-Vorrichtung nach einem der vorhergehenden Ansprüche, wobei die flexiblen Elemente der flexiblen Anschlagstruktur Torsionsfedern (315, 415, 515, 565, 815, 915, 965, 1265) umfassen.

6. MEMS-Vorrichtung nach einem der vorhergehenden Ansprüche, wobei die flexiblen Elemente (1265) der flexiblen Anschlagstruktur strukturelle Elemente umfassen, die gebogen sind, um in einen kompakten Bereich in der seismischen Masse (1205) zu passen.

7. MEMS-Vorrichtung nach einem der Ansprüche 4 bis 6, wobei die flexible Anschlagstruktur (945) eingerichtet ist, um sich elastisch zu deformieren, um vertikale Stoßkräfte zwischen der seismischen Masse (905) und der Kappenstruktur (980) abzuschwächen.

8. MEMS-Vorrichtung nach einem der Ansprüche 4 bis 7, weiterhin umfassend:
   einen Stoßdämpfer (975), der auf der Oberfläche des Substrats (907) ausgebildet ist, wobei der Kontakthebel (970) ausgerichtet ist, um den Stoßdämpfer zu kontaktieren, wenn sich die seismische Masse (905) auf das Substrat (907) hinbewegt.

9. MEMS-Vorrichtung nach Anspruch 9, wobei die flexiblen Elemente (965) mit einem Mittenabschnitt des Kontakthebels (1270) verbunden sind, der Kontakthebel (1270) zwei Enden aufweist, die sich in entgegengesetzte Richtungen erstrecken, ein Ende des Kontakthebels (1270) ausgerichtet ist, um den Stoßdämpfer (1275) zu kontaktieren, und

ein anderes Ende des Kontakthebels (1270) ausgerichtet ist, um einen anderen Stoßdämpfer (1275) zu kontaktieren.

10. MEMS-Vorrichtung nach einem der vorhergehenden Ansprüche, wobei
die flexible Anschlagstruktur (345, 445, 945, 1245) entlang einer Mittellinie (830) der MEMS-Vorrichtung zentriert ist oder von dieser dezentriert ist, die Mittellinie von zwei parallelen Seiten der MEMS-Vorrichtung äquidistant ist, und
die Mittellinie senkrecht zu einer Rotationsachse (825) ist, um die sich die seismische Masse bewegt.

11. MEMS-Vorrichtung nach einem der vorhergehenden Ansprüche, weiterhin Folgendes umfassend:
eine umgebende Struktur (835), welche die seismische Masse (805) lateral umgibt, wobei
die umgebende Struktur (835) einen oder mehrere laterale Stopper (840) umfasst, die eingerichtet sind, um laterale Stoßkräfte zwischen der seismischen Masse (805) und der umgebenden Struktur (835) abzuschwächen.

12. Verfahren zum Herstellen einer mikroelektromechanischen Systeme-, MEMS, -Vorrichtung, Folgendes umfassend:

Ausbilden (1305) mindestens eines Stoßdämpfers (575, 975, 1275) auf einem Substrat (307, 407, 507, 907);
Abscheiden (1310) mindestens einer Opferschicht über dem mindestens einen Stoßdämpfer;
Ätzen (1315) mindestens einer Öffnung für eine Verankerung (910) in die mindestens eine Opferschicht;
Abscheiden (1320) einer Strukturschicht über der mindestens einen Opferschicht und innerhalb der mindestens einen Öffnung;
Ätzen (1325) der Strukturschicht, um eine seismische Masse (305, 405, 505, 805, 905, 1205) und eine flexible Anschlagstruktur (345, 445, 045, 1245) in der seismischen Masse auszubilden, wobei das Ätzen Folgendes umfasst:
Ätzen einer ersten Öffnung und einer zweiten Öffnung, um einen Kontakthebel (470, 570, 970, 1270) und Torsionsfedern (315, 415, 515, 565, 815, 915, 965, 1265) auszubilden, die den Kontakthebel mit der seismischen Masse verbinden, wobei der Kontakthebel mit dem mindestens einen Stoßdämpfer ausgerichtet ist; und
Entfernen (1330) der Opferschicht, um die seismische Masse freizugeben, wobei die seismische Masse eingerichtet ist, um sich hinsichtlich einer Oberfläche des Substrats zu bewegen; wobei eine untere Oberfläche des Kontakthebels (470, 570, 970, 1270) koplanar mit einer unteren Oberfläche der seismischen Masse (305, 405, 505, 805, 905, 1205) ist.

**Revendications**

1. Dispositif de systèmes microélectromécaniques, MEMS, comprenant :

un substrat (307, 407, 507, 907) ;
une masse étalon (305, 405, 505, 805, 905, 1205) positionnée dans un espace au-dessus d'une surface du substrat, dans lequel la masse étalon est configurée pour se déplacer relativement au substrat ;
une structure d'arrêt de déplacement flexible (345, 445, 945, 1245) formée à l'intérieur de la masse étalon, dans lequel
la structure d'arrêt de déplacement flexible comprend un levier de contact (470, 570, 970, 1270) raccordé à la masse étalon par l'intermédiaire d'éléments flexibles (315, 415, 515, 565, 815, 915, 965, 1265) ; et
un amortisseur (575, 975, 1275) formé sur la surface du substrat, dans lequel
le levier de contact (470, 570, 970, 1270) est aligné pour entrer en contact avec l'amortisseur (575, 975, 1275) lorsque la masse étalon se déplace vers le substrat ;
dans lequel une surface inférieure du levier de contact (470, 570, 970, 1270) est coplanaire avec une surface inférieure de la masse étalon (305, 405, 505, 805, 905, 1205), avant d'entrer en contact avec l'amortisseur (575, 975, 1275).

2. Dispositif de MEMS selon la revendication 1, dans lequel
la structure d'arrêt de déplacement flexible (345, 445, 945, 1245) est configurée pour se déformer élastiquement pour mitiger des forces d'impact verticales entre la masse étalon (305, 405, 505, 805, 905, 1205) et le substrat (307, 407, 507, 907).

3. Dispositif de MEMS selon la revendication 1 ou la revendication 2, dans lequel
les éléments flexibles (1265) sont raccordés à une portion centrale du levier de contact (1270), le levier de contact (1270) a deux extrémités s'étendant dans des directions opposées,
une extrémité du levier de contact (1270) est alignée pour entrer en contact avec l'amortisseur (1275), et
une autre extrémité du levier de contact (1270) est alignée pour entrer en contact avec un autre amortisseur (1275).

4. Dispositif de systèmes microélectromécaniques, MEMS, comprenant :

un substrat (907) ;
une masse étalon (905) positionnée dans un espace au-dessus d'une surface du substrat, dans lequel la masse étalon est configurée pour se déplacer relativement au substrat ;
une structure d'arrêt de déplacement flexible (945) formée à l'intérieur de la masse étalon, dans lequel
la structure d'arrêt de déplacement flexible (945) comprend un levier de contact (970) raccordé à la masse étalon (905) par l'intermédiaire d'éléments flexibles (1265) ; et
une structure coiffe (980) attachée à la surface du substrat (907) qui s'étend au-dessus de la masse étalon (905), dans lequel
la structure coiffe (980) comprend une extension (987) alignée avec le levier de contact (970), et le levier de contact (970) est aligné pour entrer en contact avec l'extension lorsque la masse étalon (905) s'éloigne du substrat (907).

5. Dispositif de MEMS selon l'une quelconque des revendications précédentes, dans lequel
les éléments flexibles de la structure d'arrêt de déplacement flexible comprennent des ressorts de torsion (315, 415, 515, 565, 815, 915, 965, 1265).

6. Dispositif de MEMS selon l'une quelconque des revendications précédentes, dans lequel
les éléments flexibles (1265) de la structure d'arrêt de déplacement flexible comprennent des éléments structurels cintrés pour aller à l'intérieur d'une zone compacte à l'intérieur de la masse étalon (1205).

7. Dispositif de MEMS selon l'une quelconque des revendications 4 à 6, dans lequel
la structure d'arrêt de déplacement flexible (945) est configurée pour se déformer élastiquement pour mitiger des forces d'impact verticales entre la masse étalon (905) et la structure de coiffe (980).

8. Dispositif de MEMS selon l'une quelconque des revendications 4 à 7, comprenant en outre :
un amortisseur (975) formé sur la surface du substrat (907), dans lequel
le levier de contact (970) est aligné pour entrer en contact avec l'amortisseur (975) lorsque la masse étalon (905) se déplace vers le substrat (907).

9. Dispositif de MEMS selon la revendication 9, dans lequel
les éléments flexibles (965) sont raccordés à une portion centrale du levier de contact (1270),
le levier de contact (1270) a deux extrémités s'étendant dans des directions opposées,
une extrémité du levier de contact (1270) est alignée pour entrer en contact avec l'amortisseur (1275), et une autre extrémité du levier de contact (1270) est alignée pour entrer en contact avec un autre amortisseur (1275).

10. Dispositif de MEMS selon l'une quelconque des revendications précédentes, dans lequel
la structure d'arrêt de déplacement flexible (345, 445, 945, 1245) est centrée le long d'une ligne médiane (830) du dispositif de MEMS ou est excentrée par rapport à celle-ci,
la ligne médiane est équidistante de deux côtés parallèles du dispositif de MEMS, et
la ligne médiane est perpendiculaire à un axe de rotation (825) autour duquel la masse étalon se déplace.

11. Dispositif de MEMS selon l'une quelconque des revendications précédentes, comprenant en outre :
une structure d'encerclement (835) qui encercle latéralement la masse étalon (805), dans lequel
la structure d'encerclement (835) comprend une ou plusieurs butées latérales (840) configurées pour mitiger des forces d'impact latérales entre la masse étalon (805) et la structure d'encerclement (835).

12. Procédé de fabrication d'un dispositif de systèmes microélectromécaniques, MEMS, comprenant :

la formation (1305) d'au moins un amortisseur (575, 975, 1275) sur un substrat (307, 407, 507, 907) ;
le dépôt (1310) d'au moins une couche sacrificielle sur l'au moins une amortisseur ;
la gravure (1315) d'au moins une ouverture pour un ancrage (910) dans l'au moins une couche sacrificielle ;
le dépôt (1320) d'une couche structurelle sur l'au moins une couche sacrificielle et à l'intérieur de l'au moins une ouverture ;
la gravure (1325) de la couche structurelle pour former une masse étalon (305, 405, 505, 805, 905, 1205) et une structure d'arrêt de déplacement flexible (345, 445, 045, 1245) à l'intérieur de la masse étalon, dans lequel la gravure comprend :
la gravure d'une première ouverture et d'une seconde ouverture pour former un levier de contact (470, 570, 970, 1270) et des ressorts de torsion (315, 415, 515, 565, 815, 915, 965, 1265) raccordant le levier de contact à la masse étalon, dans lequel le levier de contact est aligné avec l'au moins une amortisseur ; et
l'enlèvement (1330) de la couche sacrificielle pour libérer la masse étalon, dans lequel la masse étalon est configurée pour se déplacer relativement à une surface du substrat ;
dans lequel une surface inférieure du levier de contact (470, 570, 970, 1270) est coplanaire avec une surface inférieure de la masse étalon (305, 405, 505, 805, 905, 1205).

FIG. 1
- PRIOR ART -

FIG. 2
- PRIOR ART -

EP 3 121 145 B1

FIG. 3

FIG. 4

EP 3 121 145 B1

FIG. 5

FIG. 6

EP 3 121 145 B1

FIG. 7

FIG. 8

FIG. 9

FIG. 10

EP 3 121 145 B1

FIG. 11

FIG. 12

1305 — FORM BUMPER(S) AND ELECTRODES

1310 — DEPOSIT SACRIFICIAL LAYER(S)

1315 — ETCH OPENING FOR ANCHOR INTO SACRIFICIAL LAYER(S)

1320 — DEPOSIT STRUCTURAL LAYER

1325 — ETCH STRUCTURAL LAYER TO FORM PROOF MASS, TORSION SPRINGS, AND FLEXIBLE STOP

1330 — REMOVE SACRIFICIAL LAYER TO RELEASE PROOF MASS

FIG. 13

**EP 3 121 145 B1**

**REFERENCES CITED IN THE DESCRIPTION**

**Patent documents cited in the description**

- JP 2011112620 A